# EUROPÄISCHE PATENTSCHRIFT

(11) **EP 2 885 837 B1**
(45) Veröffentlichungstag und Bekanntmachung des Hinweises auf die Patenterteilung: **20.02.2019**
(21) Anmeldenummer: 12775184.0
(22) Anmeldetag: 26.09.2012
(51) Int. Cl.: H01P 5/08, H03F 3/45

(54) **VORRICHTUNG ZUM EINKOPPELN VON HF-LEISTUNG IN EINEN WELLENLEITER**
DEVICE FOR COUPLING HF-POWER INTO A WAVEGUIDE
DISPOSITIF D'INJECTION DE PUISSANCE HF DANS UN GUIDE D'ONDES

(43) Veröffentlichungstag der Anmeldung: 24.06.2015
(73) Patentinhaber: Siemens Aktiengesellschaft, 80333 München (DE)
(72) Erfinder: HEID, Oliver, 91052 Erlangen (DE); HUGHES, Timothy, 91056 Erlangen (DE)
(86) Internationale Anmeldenummer: PCT/EP2012/068922
(87) Internationale Veröffentlichungsnummer: WO 2014/048458

(56) Entgegenhaltungen:
- US-A- 2 169 305
- US-A- 3 109 144
- US-A- 4 070 639
- HEID O ET AL: "Compact Solid State Direct drive RF Linac", PROCEEDINGS OF IPAC (2010) KYOTO, JAPAN, , 23. Mai 2010 (2010-05-23), Seiten 4278-4280, XP002658698, ISBN: 978-92-9083-352-9 Gefunden im Internet: URL:http://accelconf.web.cern.ch/AccelConf /IPAC10/papers/thpd002.pdf [gefunden am 2011-09-08]

## Beschreibung

Die vorliegende Erfindung betrifft eine Vorrichtung zum Einkoppeln von HF-Leistung in einen Wellenleiter gemäß Patentanspruch 1 sowie eine Wellenleiteranordnung gemäß Patentanspruch 5. Hochfrequenzkavitäten (Hochfrequenzresonatoren) werden beispielsweise in Teilchenbeschleunigern zur Beschleunigung elektrisch geladener Teilchen verwendet. Um in einer derartigen HF-Kavität eine hochfrequente elektromagnetische Schwingung anzuregen, muss der HF-Kavität HF-Leistung zugeführt werden. Es ist bekannt, HF-Leistung, beispielsweise mittels einer Tetrode oder eines Klystrons, an einem ersten Ort zu erzeugen, und der an einem zweiten Ort angeordneten HF-Kavität über einen Wellenleiters zuzuführen. Der Wellenleiter kann beispielsweise über eine Öffnung oder per induktiver Kopplung an die HF-Kavität angebunden sein. Die verschiedenen Übergangsstellen müssen dabei genau aufeinander abgestimmt werden. Dennoch ist jede Übergangsstelle mit unvermeidlichen Leistungsverlusten verbunden.

US 4,070,639 beschreibt einen Mikrowellen-Phasenschieber, der beispielsweise bei einer phasengesteuerten Gruppenantenne verwendet werden kann. Dieser umfasst eine Induktionsschleife und eine Filteranordnung. US 2,169,305 beschreibt Schaltkreise mit einem niedrigen Verlust.

Eine Aufgabe der vorliegenden Erfindung besteht darin, eine verbesserte Vorrichtung zum Einkoppeln von HF-Leistung in einen Wellenleiter bereitzustellen. Diese Aufgabe wird durch eine Vorrichtung mit den Merkmalen des Anspruchs 1 gelöst. Eine weitere Aufgabe der vorliegenden Erfindung besteht darin, eine verbesserte Wellenleiteranordnung bereitzustellen. Diese Aufgabe wird durch eine Wellenleiteranordnung mit den Merkmalen des Anspruchs 5 gelöst. Bevorzugte Weiterbildungen sind in den abhängigen Ansprüchen angegeben.

Eine erfindungsgemäße Vorrichtung zum Einkoppeln von HF-Leistung in einen Wellenleiter umfasst eine Gegentaktendstufe mit einem Eingang und einem Ausgang, eine Filteranordnung, die mit dem Ausgang der Gegentaktendstufe verbunden ist, und eine Induktionsschleife, die mit der Filteranordnung verbunden ist. Vorteilhafterweise verbindet diese Vorrichtung die Gegentaktendstufe zum Erzeugen von HF-Leistung mit der Induktionsschleife zum Einkoppeln der HF-Leistung in einen Wellenleiter. Dadurch erlaubt die Vorrichtung eine Erzeugung von HF-Leistung unmittelbar am Ort der Einkopplung der HF-Leistung, wodurch sich die Komplexität der Gesamtanordnung reduziert. Die Vorrichtung ist vorteilhafterweise inhärent modular. Durch eine Verwendung einer Mehrzahl solcher Vorrichtungen ist eine Skalierung der erzeugbaren HF-Leistung problemlos möglich. Dadurch lassen sich vorteilhafterweise auch sehr hohe HF-Leistungen erreichen. Die durch Parallelisierung erreichbare Skalierbarkeit geht außerdem vorteilhafterweise mit einer unmittelbaren Erhöhung der Zuverlässigkeit einher. Durch die Integration der Filteranordnung in die Vorrichtung ist vorteilhafterweise ein hocheffizienter Betrieb der Vorrichtung möglich.

In der erfindungsgemäßen Vorrichtung umfasst die Filteranordnung einen ersten Oberwellenfilter und einen zweiten Oberwellenfilter. Vorteilhafterweise können die Oberwellenfilter der Filteranordnung unterschiedliche Filtercharakteristiken für unterschiedliche harmonische Oberwellen einer festgelegten Frequenz aufweisen.

In der erfindungsgemäßen Vorrichtung bietet der erste Oberwellenfilter bei einer Grundschwingung einer festgelegten Frequenz eine festgelegte endliche Impedanz. Vorteilhafterweise bewirkt die Filteranordnung dann eine unverfälschte Einkopplung der Grundschwingung in den Wellenleiter.

In der erfindungsgemäßen Vorrichtung wirkt der erste Oberwellenfilter bezüglich einer dritten Harmonischen der festgelegten Frequenz als offenes Leitungsende. Vorteilhafterweise ermöglicht dies der Gegentaktendstufe ein schnelles Umschalten mit großer Flankensteilheit, wodurch Umschaltverluste vorteilhafterweise minimiert werden können.

In der erfindungsgemäßen Vorrichtung wirkt der zweite Oberwellenfilter bezüglich einer zweiten Harmonischen der festgelegten Frequenz als kurzgeschlossenes Leitungsende. Vorteilhafterweise wird dadurch erreicht, dass in der Gegentaktendstufe beim Umschalten möglichst geringe Spannungen anliegen und möglichst kleine Ströme fließen, wodurch sich Umschaltverluste minimieren lassen.

In einer Ausführungsform der Vorrichtung bewirkt die Filteranordnung bezüglich einer dritten Harmonischen der festgelegten Frequenz einen Reflexionsfaktor von mindestens 0,8. Vorteilhafterweise wirkt die Filteranordnung bezüglich einer dritten Harmonischen der festgelegten Frequenz dann nährungsweise als offenes Leitungsende.

In einer Ausführungsform der Vorrichtung bewirkt die Filteranordnung bezüglich einer zweiten Harmonischen der festgelegten Frequenz einen Reflexionsfaktor von kleiner als -0,8. Vorteilhafterweise wirkt die Filteranordnung bezüglich der zweiten Harmonischen der festgelegten Frequenz dann nährungsweise als kurzgeschlossenes Leitungsende.

In einer Ausführungsform der Vorrichtung umfasst diese eine Koppelplatte. Dabei ist die Induktionsschleife an der Koppelplatte angeordnet. Außerdem ist die Koppelplatte dazu vorgesehen, in einer Öffnung einer Wandung eines Wellenleiters angeordnet zu werden. Vorteilhafterweise kann die Induktionsschleife dann derart im Inneren des Wellenleiters angeordnet werden, dass mittels der Induktionsschleife eine elektromagnetische Schwingungsmode in dem Wellenleiter angeregt werden kann. Die Koppelplatte erlaubt dabei vorteilhafterweise eine einfache mechanische Kopplung der Vorrichtung mit dem Wellenleiter.

Eine erfindungsgemäße Wellenleiteranordnung umfasst einen Wellenleiter und eine Vorrichtung der vorgenannten Art. Vorteilhafterweise kann bei dieser Wellenleiteranordnung mit der Vorrichtung HF-Leistung erzeugt und unmittelbar in den Wellenleiter eingekoppelt werden. Dadurch ist die Wellenleiteranordnung kompakt ausgebildet und weist eine nur geringe Komplexität auf.

In einer Ausführungsform der Wellenleiteranordnung weist diese zwei Vorrichtungen der oben beschriebenen Art auf. Vorteilhafterweise addieren sich bei dieser Wellenleiteranordnung die mittels der zwei Vorrichtungen erzeugten HF-Leistungen, wodurch eine insgesamt höhere HF-Leistung in den Wellenleiter eingekoppelt werden kann. Durch das Vorsehen zweier Vorrichtungen zum Einkoppeln von HF-Leistung reduziert sich auch eine Wahrscheinlichkeit eines gleichzeitigen Ausfalls beider Vorrichtungen zum Einkoppeln von HF-Leistung der Wellenleiteranordnung.

In einer Ausführungsform der Wellenleiteranordnung ist der Wellenleiter ein koaxialer Wellenleiter. Vorteilhafterweise kann die Vorrichtung dann in einer Aussparung eines Außenleiters des koaxialen Wellenleiters angeordnet sein.

In einer anderen Ausführungsform der Wellenleiteranordnung ist der Wellenleiter ein Hohlleiter. Vorteilhafterweise kann die Vorrichtung zum Einkoppeln von HF-Leistung dann an einer Position des Hohlleiters angeordnet sein, um eine gewünschte Schwingungsmode im Hohlleiter anzuregen.

In einer Ausführungsform der Wellenleiteranordnung ist der Wellenleiter mit einer HF-Kavität verbunden. Vorteilhafterweise kann die durch die Vorrichtung generierte und in den Wellenleiter eingekoppelte HF-Leistung dann über den Wellenleiter in die HF-Kavität eingespeist werden.

Die oben beschriebenen Eigenschaften, Merkmale und Vorteile dieser Erfindung, sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden. Hierbei zeigen in jeweils schematischer Darstellung:
Figur 1 eine Wellenleiteranordnung mit einer Vorrichtung zum Einkoppeln von HF-Leistung und einem koaxialen Wellenleiter;
Figur 2 eine Wellenleiteranordnung mit einem Hohlwellenleiter;
Figur 3 eine Wellenleiteranordnung mit mehreren Vorrichtungen zum Einkoppeln von HF-Leistung;
Figur 4 eine weitere Wellenleiteranordnung mit mehreren Vorrichtungen zum Einkoppeln von HF-Leistung; und
Figur 5 eine Wellenleiteranordnung mit einer Kavität.

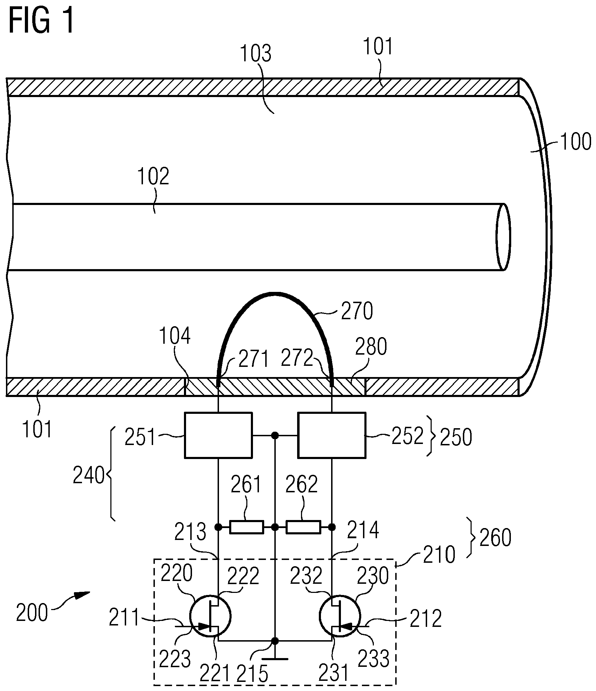

Figur 1 zeigt in stark schematisierter Darstellung eine Wellenleiteranordnung 10. Die Wellenleiteranordnung 10 umfasst einen koaxialen Wellenleiter 100 und eine Vorrichtung 200 zum Einkoppeln von HF-Leistung in den koaxialen Wellenleiter 100. Die Wellenleiteranordnung 10 kann beispielsweise dazu dienen, HF-Leistung zu erzeugen und in eine HF-Kavität einzuspeisen. Die HF-Kavität kann wiederum beispielsweise zur Beschleunigung geladener Teilchen in einem Teilchenbeschleuniger dienen.

Figur 1 zeigt lediglich einen kurzen Längsabschnitt des koaxialen Wellenleiters 100. Der koaxiale Wellenleiter 100 weist einen Außenleiter 101 auf, der koaxial zu einem Innenleiter 102 angeordnet ist und diesen konzentrisch umhüllt. Der Außenleiter 101 und der Innenleiter 102 bestehen jeweils aus einem elektrisch leitenden Material. Beispielsweise können der Außenleiter 101 und der Innenleiter 102 Kupfer aufweisen. Der Außenleiter weist bevorzugt eine hohlzylindrische Form mit kreisförmigem Querschnitt auf. Der Innenleiter 102 weist bevorzugt eine kreiszylindrische Form auf. Zwischen dem Außenleiter 101 und dem Innenleiter 102 ist ein Dielektrikum 103 angeordnet. Der Außenleiter 101 des koaxialen Wellenleiters 100 weist eine Öffnung 104 auf.

Die Vorrichtung 200 zum Einkoppeln von HF-Leistung umfasst eine Gegentaktendstufe 210, eine Filteranordnung 240 und eine Induktionsschleife 270. Alle Komponenten sind in Figur lediglich beispielhaft und schematisch dargestellt. Die Gegentaktendstufe 210 dient zur Erzeugung von HF-Leistung. Die Filteranordnung 240 bewirkt eine Impedanztransformation. Die Induktionsschleife 270 dient zum Einkoppeln der erzeugten HF-Leistung in den koaxialen Wellenleiter 100.

Die Gegentaktendstufe 210 weist einen ersten Eingang 211, einen zweiten Eingang 212, einen ersten Ausgang 213, einen zweiten Ausgang 214 und einen Massekontakt 215 auf. Am ersten Eingang 211 und am zweiten Eingang 212 kann der Gegentaktendstufe 210 ein beispielsweise sinusförmiges Eingangssignal zugeführt werden, wobei die Polaritäten am ersten Eingang 211 und am zweiten Eingang 212 zueinander invers sind. Über den ersten Ausgang 213 und den zweiten Ausgang 214 kann die Gegentaktendstufe 210 erzeugte HF-Leistung ausgeben.

Im dargestellten schematischen Beispiel weist die Gegentaktendstufe 210 einen ersten Transistor 220 und einen zweiten Transistor 230 auf. Die Gegentaktendstufe 210 könnte aber selbstverständlich noch weitere Bauteile umfassen. Der erste Transistor 220 ist als n-Kanal-Sperrschicht-Feldeffekttransistor ausgebildet und weist einen Source-Kontakt 221, einen Drain-Kontakt 222 und einen Gate-Kontakt 223 auf. Der zweite Transistor 230 ist ebenfalls als n-Kanal-Sperrschicht-Feldeffekttransistor ausgebildet und weist einen Source-Kontakt 231, einen Drain-Kontakt 232 und einen Gate-Kontakt 233 auf. Der Source-Kontakt 221 des ersten Transistors 220 und der Source-Kontakt 231 des zweiten Transistors 230 sind mit dem Massekontakt 215 verbunden. Der Gate-Kontakt 223 des ersten Transistors 320 bildet den ersten Eingang 211 der Gegentaktendstufe 210. Der Gate-Kontakt 233 des zweiten Transistors 230 bildet den zweiten Eingang 212 der Gegentaktendstufe 210. Der Drain-Kontakt 222 des ersten Transistors 220 bildet den ersten Ausgang 213 der Gegentaktendstufe 210. Der Drain-Kontakt 232 des zweiten Transistors 230 bildet den zweiten Ausgang 214 der Gegentaktendstufe 210.

Die Filteranordnung 240 umfasst einen ersten Oberwellenfilter 250 und einen zweiten Oberwellenfilter 260. Der erste Oberwellenfilter 250 umfasst einen ersten Teil 251 und einen zweiten Teil 252. Der zweite Oberwellenfilter 260 umfasst einen ersten Teil 261 und einen zweiten Teil 262. Der erste Teil 251 des ersten Oberwellenfilters 250 ist mit dem ersten Ausgang 213 der Gegentaktendstufe 210, dem Massekontakt 215 und einem ersten Kontakt 271 der Induktionsschleife 270 verbunden. Der zweite Teil 252 des ersten Oberwellenfilters 250 ist mit dem zweiten Ausgang 214 der Gegentaktendstufe 210, dem Massekontakt 215 und einem zweiten Kontakt 272 der Induktionsschleife 270 verbunden. Der erste Teil 261 des zweiten Oberwellenfilters 260 ist mit dem ersten Ausgang 213 der Gegentaktendstufe 210 und mit dem Massekontakt 215 verbunden. Der zweite Teil 262 des zweiten Oberwellenfilters 260 ist mit dem zweiten Ausgang 214 der Gegentaktendstufe 210 und mit dem Massekontakt 215 verbunden.

Der erste Oberwellenfilter 250 kann aus diskreten Elementen oder aus Leitungsstücken aufgebaut sein. Der erste Oberwellenfilter 250 bewirkt eine Impedanztransformation, so dass eine erste Harmonische bzw. eine Grundschwingung einer festgelegten Frequenz eine festgelegte erforderliche Lastimpedanz sieht, während eine dritte Harmonische ein offenes Leitungsende oder zumindest ein angenähert offenes Leitungsende sieht. Daraus ergibt sich für die dritte Harmonische ein hoher Reflexionsfaktor, der nahe beim Wert 1 liegt. Bevorzugt liegt der Reflexionsfaktor bei mindestens 0,8.

Die durch den ersten Oberwellenfilter 250 der Filteranordnung 240 bewirkte Impedanztransformation hat zur Folge, dass die Transistoren 220, 230 der Gegentaktendstufe 210 mit hoher Flankensteilheit zwischen geöffneten und geschlossenen Zuständen umschalten können. Dadurch werden vorteilhafterweise Umschaltverluste in den Transistoren 220, 230 der Gegentaktendstufe 210 minimiert.

Durch den zweiten Oberwellenfilter 260 der Filteranordnung 240 bietet sich einer zweiter Harmonischen der festgelegten Frequenz ein angenährt kurzgeschlossenes Leitungsende. Dies hat für die zweite Harmonische einen Reflexionskoeffizienten zur Folge, der sich einem Wert von -1 annähert. Bevorzugt ist der Reflexionsfaktor für die zweite Harmonische kleiner als -0,8. Der zweite Oberwellenfilter 260 der Filteranordnung 240 bewirkt dadurch, dass an den Transistoren 220, 230 der Gegentaktendstufe 210 während der Umschaltzeitpunkte der Transistoren 220, 230 anliegende Spannungen möglichst niedrige Beträge aufweisen, und während der Umschaltzeitpunkte der Transistoren 220, 230 der Gegentaktendstufe 210 möglichst geringe Ströme fließen. Auch hierdurch werden die Umschaltverluste in den Transistoren 220, 230 der Gegentaktendstufe 210 vorteilhafterweise minimiert.

Die Induktionsschleife 270 ist an einer Koppelplatte 280 der Vorrichtung 200 zum Einkoppeln von HF-Leistung angeordnet. Die Koppelplatte 280 ist derart in der Öffnung 104 des Außenleiters 101 des koaxialen Wellenleiters 100 angeordnet, dass die Induktionsschleife 200 im Bereich des Dielektrikums 103 im Inneren des Außenleiters 101 des koaxialen Wellenleiters 100 angeordnet ist. Über ein von der Induktionsschleife 270 erzeugtes magnetisches Wechselfeld kann durch die Gegentaktendstufe 210 erzeugte HF-Leistung in den koaxialen Wellenleiter 100 eingekoppelt werden. Der koaxiale Wellenleiter 100 kann diese HF-Leistung in Längsrichtung weiterleiten.

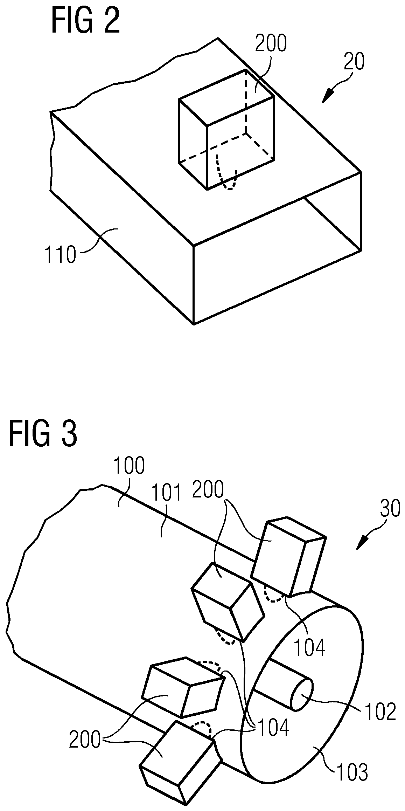

Figur 2 zeigt in schematischer Darstellung eine Wellenleiteranordnung 20 gemäß einer zweiten Ausführungsform. Bei der Wellenleiteranordnung 20 ist anstelle des koaxialen Wellenleiters 100 ein Hohlwellenleiter 110 vorgesehen. An einer Wandung des Hohlwellenleiters 10 ist eine Vorrichtung 200 zum Einkoppeln von HF-Leistung entsprechend der vorstehenden Beschreibung angeordnet. Die Vorrichtung 200 zum Einkoppeln von HF-Leistung dient dazu, HF-Leistung zu generieren und in den Hohlwellenleiter 110 einzukoppeln. Abhängig von der Position und Orientierung der Vorrichtung 200 an der Wandung des Hohlwellenleiters 110 können unterschiedliche Schwingungsmoden in dem Hohlwellenleiter 110 angeregt werden.

Figur 3 zeigt eine schematische Darstellung einer Wellenleiteranordnung 30 gemäß einer dritten Ausführungsform. Die Wellenleiteranordnung 30 umfasst einen koaxialen Wellenleiter 100. In Umfangsrichtung weist der Außenleiter 101 des koaxialen Wellenleiters 100 mehrere Öffnungen 104 auf, an denen jeweils eine Vorrichtung 200 zum Einkoppeln von HF-Leistung angeordnet ist. Jede dieser Vorrichtungen 200 zum Einkoppeln von HF-Leistung dient zum Erzeugen von HF-Leistung und zum Einkoppeln dieser erzeugten HF-Leistung in den koaxialen Wellenleiter 100.

Durch das Vorhandensein mehrerer Vorrichtungen 200 kann insgesamt eine höhere HF-Leistung erzeugt und in den Wellenleiter 100 eingekoppelt werden. Durch das Vorhandensein mehrerer Vorrichtungen 200 reduziert sich auch die Gefahr eines vollständigen Ausfalls der Wellenleiteranordnung 30. Selbst bei einem Ausfall einer oder mehrerer Vorrichtungen 200 zum Einkoppeln von HF-Leistung kann mit den übrigen Vorrichtungen 200 weiter HF-Leistung in den koaxialen Wellenleiter 100 eingekoppelt werden.

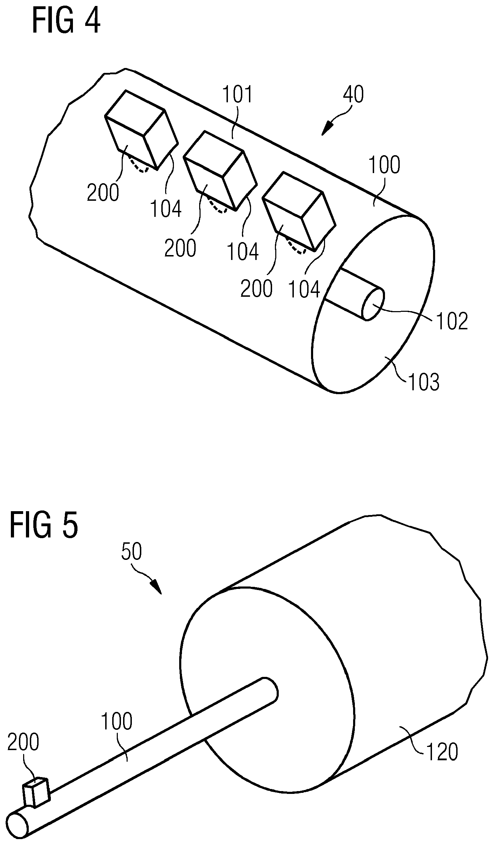

Figur 4 zeigt eine schematische Darstellung einer Wellenleiteranordnung 40 gemäß einer vierten Ausführungsform. Die Wellenleiteranordnung 40 umfasst einen koaxialen Wellenleiter 100. Entlang einer Längsrichtung des koaxialen Wellenleiters 100 weist der Außenleiter 101 des koaxialen Wellenleiters 100 eine Mehrzahl an Öffnungen 104 auf. An jeder dieser Öffnungen 104 ist jeweils eine Vorrichtung 200 zum Einkoppeln von HF-Leistung angeordnet. Jede der Vorrichtungen 200 dient wiederum dazu, HF-Leistung zu erzeugen und in den koaxialen Wellenleiter 100 einzukoppeln.

Auch die lineare Anordnung einer Mehrzahl von Vorrichtungen 200 erlaubt es, eine insgesamt höhere HF-Leistung in den koaxialen Wellenleiter 100 einzukoppeln, als bei Vorhandensein lediglich einer Vorrichtung 200 zum Einkoppeln von HF-Leistung. Durch das Vorhandensein mehrerer Vorrichtungen 200 sinkt außerdem wiederum die Gefahr eines vollständigen Ausfalls der Wellenleiteranordnung 40.

Figur 5 zeigt eine perspektivische Darstellung einer Wellenleiteranordnung 50 gemäß einer fünften Ausführungsform. Die Wellenleiteranordnung 50 umfasst einen koaxialen Wellenleiter 100, der mit einer Vorrichtung 200 zum Einkoppeln von HF-Leistung in den koaxialen Wellenleiter 100 verbunden ist. Außerdem weist die Wellenleiteranordnung 50 eine HF-Kavität 120 auf. Die Kavität 120 kann auch als Hohlraumresonator bezeichnet werden. Die Kavität 120 kann beispielsweise Teil eines Teilchenbeschleunigers sein und zum Beschleunigen elektrisch geladener Teilchen dienen. Der koaxiale Wellenleiter 100 der Wellenleiteranordnung 50 ist derart mit der Kavität 120 verbunden, dass durch die Vorrichtung 200 in den koaxialen Wellenleiter 100 eingekoppelte HF-Leistung über den koaxialen Wellenleiter 100 zur Kavität 120 transportiert und in die Kavität 120 eingespeist wird.

Obwohl die Erfindung im Detail durch das bevorzugte Ausführungsbeispiel näher illustriert und beschrieben wurde, ist die Erfindung nicht durch die offenbarten Beispiels eingeschränkt. Andere Variationen können vom Fachmann hieraus abgeleitet werden, ohne den Schutzumfang der Erfindung zu verlassen.

## Patentansprüche

1. Vorrichtung (200) zum Einkoppeln von HF-Leistung in einen Wellenleiter (100, 110)
mit einer Filteranordnung (240), einer Induktionsschleife (270), die dazu vorgesehen ist, im Inneren eines Wellenleiters (100, 110) angeordnet zu werden, um HF-Leistung in den Wellenleiter (100, 110) einzukoppeln,
wobei die Induktionsschleife (270) mit der Filteranordnung (240) verbunden ist,
und einer Gegentaktendstufe (210) mit einem Eingang (211, 212) und einem Ausgang (213, 214),
wobei die Filteranordnung (240) mit dem Ausgang (213, 214) der Gegentaktendstufe (210) verbunden ist,
**dadurch gekennzeichnet, dass** die Filteranordnung (240) einen ersten Oberwellenfilter (250) und einen zweiten Oberwellenfilter (260) umfasst, wobei der erste Oberwellenfilter (250) bei einer Grundschwingung einer festgelegten Frequenz eine festgelegte endliche Impedanz bietet,
wobei der erste Oberwellenfilter (250) bezüglich einer dritten Harmonischen der festgelegten Frequenz als offenes Leitungsende wirkt,
wobei der zweite Oberwellenfilter (260) bezüglich einer zweiten Harmonischen der festgelegten Frequenz als kurzgeschlossenes Leitungsende wirkt.

2. Vorrichtung (200) gemäß Anspruch 1, wobei die Filteranordnung (240) bezüglich einer dritten Harmonischen der festgelegten Frequenz einen Reflexionsfaktor von mindestens 0,8 bewirkt.

3. Vorrichtung (200) gemäß einem der Ansprüche 1 und 2, wobei die Filteranordnung (240) bezüglich einer zweiten Harmonischen der festgelegten Frequenz einen Reflexionsfaktor von kleiner als -0,8 bewirkt.

4. Vorrichtung (200) gemäß einem der vorhergehenden Ansprüche,
wobei die Vorrichtung (200) eine Koppelplatte (280) umfasst,
wobei die Induktionsschleife an der Koppelplatte (280) angeordnet ist, wobei die Koppelplatte (280) dazu vorgesehen ist, in einer Öffnung (104) einer Wandung (101) eines Wellenleiters (100, 110) angeordnet zu werden.

5. Wellenleiteranordnung (10, 20, 30, 40, 50) mit einem Wellenleiter (100, 110) und einer Vorrichtung (200) gemäß einem der vorherigen Ansprüche.

6. Wellenleiteranordnung (30, 40) gemäß Anspruch 5, wobei die Wellenleiteranordnung (30, 40) zwei Vorrichtungen (200) gemäß einem der Ansprüche 1 bis 4 aufweist.

7. Wellenleiteranordnung (10, 30, 40, 50) gemäß einem der Ansprüche 5 und 6,
wobei der Wellenleiter (100) ein koaxialer Wellenleiter ist.

8. Wellenleiteranordnung (20) gemäß einem der Ansprüche 5 und 6,
wobei der Wellenleiter (110) ein Hohlleiter ist.

9. Wellenleiteranordnung (50) gemäß einem der Ansprüche 5 bis 8, wobei der Wellenleiter (100) mit einer HF-Kavität (120) verbunden ist.

## Claims

1. Device (200) for coupling RF power into a waveguide (100, 110), comprising
a filter arrangement (240),
an induction loop (270) which is provided to be arranged in the interior of a waveguide (100, 110) in order to couple RF power into the waveguide (100, 110),
wherein the induction loop (270) is connected to the filter arrangement (240),
and a push-pull output stage (210) having an input (211, 212) and an output (213, 214),
wherein the filter arrangement (240) is connected to the output (213, 214) of the push-pull output stage (210),
**characterized in that** the filter arrangement (240) comprises a first harmonic filter (250) and a second harmonic filter (260) wherein the first harmonic filter (250) provides a fixed finite impedance for a fundamental oscillation with a fixed frequency, wherein the first harmonic filter (250) acts as an open line termination for a third harmonic of the fixed frequency,
wherein the second harmonic filter (260) acts as a shortcircuited line termination for a second harmonic of the fixed frequency.

2. Device (200) according to Claim 1,
wherein the filter arrangement (240) induces a reflection factor of at least 0.8 for a third harmonic of the fixed frequency.

3. Device (200) according to one of Claims 1 and 2,
wherein the filter arrangement (240) induces a reflection factor of less than -0.8 for a second harmonic of the fixed frequency.

4. Device (200) according to one of the preceding claims,
wherein the device (200) comprises a coupling plate (280),
wherein the induction loop is arranged on the coupling plate (280),
wherein the coupling plate (280) is intended to be arranged in an opening (104) of a wall (101) of a waveguide (100, 110).

5. Waveguide arrangement (10, 20, 30, 40, 50) having a waveguide (100, 110) and a device (200) according to one of the preceding claims.

6. Waveguide arrangement (30, 40) according to Claim 5,
wherein the waveguide arrangement (30, 40) comprises two devices (200) according to one of Claims 1 to 4.

7. Waveguide arrangement (10, 30, 40, 50) according to one of Claims 5 and 6,
wherein the waveguide (100) is a coaxial waveguide.

8. Waveguide arrangement (20) according to one of Claims 5 and 6,
wherein the waveguide (110) is a hollow conductor.

9. Waveguide arrangement (50) according to one of Claims 5 to 8,
wherein the waveguide (100) is connected to an RF cavity (120) .

## Revendications

1. Dispositif (200) d'injection de puissance HF dans un guide d'ondes (100, 110),
comprenant un système (240) de filtre,
une boucle (270) d'induction, prévue pour être mise à l'intérieur d'un guide d'ondes (100, 110), afin d'injecter de la puissance HF dans le guide d'ondes (100, 110),
la boucle (270) d'induction étant reliée au système (240) de filtre,
et
un étage (210) de sortie push pull ayant une entrée (211, 212) et une sortie (213, 214),
dans lequel le système (240) de filtre est relié à la sortie (213, 214) de l'étage (210) de sortie push pull, **caractérisé en ce que**
le système (240) de filtre comprend un premier filtre (250) d'harmonique et un deuxième filtre (260) d'harmonique, le premier filtre (250) d'harmonique donnant une impédance finale fixée à une oscillation fondamentale d'une fréquence fixée,
dans lequel le premier filtre (250) d'harmonique agit en extrémité de ligne ouverte, en ce qui concerne un troisième harmonique de la fréquence fixée,
dans lequel le deuxième filtre (260) d'harmonique agit en extrémité de ligne court-circuitée, en ce qui concerne un deuxième harmonique de la fréquence fixée.

2. Dispositif (200) suivant la revendication 1,
dans lequel le système (240) de filtre donne, en ce qui concerne un troisième harmonique de la fréquence fixée, un facteur de réflexion d'au moins 0,8.

3. Dispositif (200) suivant l'une des revendications 1 et 2, dans lequel le système (240) de filtre donne, en ce qui concerne un deuxième harmonique de la fréquence fixée, un facteur de réflexion plus petit que -0,8.

4. Dispositif (200) suivant l'une des revendications précédentes,
dans lequel le dispositif (200) comprend une plaque (280) de couplage,
dans lequel la boucle d'induction est montée sur la plaque (280) de couplage,
dans lequel la plaque (280) de couplage est prévue pour être disposée dans une ouverture (104) d'une paroi (101) d'un guide d'ondes (100, 110).

5. Système (10, 20, 30, 40, 50) de guide d'ondes,
ayant un guide d'ondes (100, 110) et un dispositif (200) suivant l'une des revendications précédentes.

6. Système (30, 40,) de guide d'ondes suivant la revendication 5,
dans lequel le système (30, 40) de guide d'ondes a deux dispositifs (200) suivant l'une des revendications 1 à 4.

7. Système (10, 30, 40, 50) de guide d'ondes suivant l'une des revendications 5 et 6,
dans lequel le guide d'ondes (100) est un guide d'ondes coaxial.

8. Système (20) de guide d'ondes suivant l'une des revendications 5 et 6,
dans lequel le guide d'ondes (110) est tubulaire.

9. Système (50) de guide d'ondes suivant l'une des revendications 5 à 8,
dans lequel le guide d'ondes (100) est relié à une cavité (120) HF.
